# EUROPÄISCHE PATENTANMELDUNG

(11) **EP 0 897 172 A2**
(43) Veröffentlichungstag der Anmeldung: **17.02.1999**
(21) Anmeldenummer: 98115077.4
(22) Anmeldetag: 11.08.1998
(51) Int. Cl.: G09F 9/33

(54) **Displayanordnung zum Anzeigen von Informationen und deren Verwendung sowie ein Verfahren zu deren Herstellung**

(30) Priorität: 11.08.1997 DE 19734792; 05.09.1997 DE 19738972
(71) Anmelder: MAN Technologie AG, 86153 Augsburg (DE)
(72) Erfinder: Malcherek, Werner, Dipl.-Ing. (FH), 85221 Dachau (DE)
(74) Vertreter: Grape, Knut, Dipl.-Ing.

(57) **Zusammenfassung**

Die Erfindung betrifft eine Displayanordnung zum Anzeigen von Informationen mit einer Vielzahl von lichtemittierenden Elementen (12), die zueinander benachbart angeordnet und individuell ansteuerbar sind, wobei den lichtemittierenden Elementen (12) wenigstens ein Element (24, 34, 36, 40, 50, 54, 58) zur Vergrößerung und/oder Formgebung der von den lichtemittierenden Elementen (12) ausgesendeten Lichtstrahlen (26) zugeordnet ist.

## Beschreibung

Die Erfindung betrifft eine Displayanordnung zum Anzeigen von Informationen und deren Verwendung sowie ein Verfahren zu deren Herstellung.

Displayanordnungen zum Anzeigen von Informationen sind allgemein bekannt. So sind derartige Displayanordnungen häufig in Fahrzeugen, insbesondere Schienenfahrzeugen, zur Beförderung von Personen, wie beispielsweise in Eisenbahnwaggons, U-Bahnen und öffentlichen Bussen zum Anzeigen einer Reservierung von bestimmten Plätzen, der nächsten Haltestelle etc., anzutreffen. Ebenso finden derartige Displayanordnungen in stationären Systemen, wie zum Beispiel im Bereich von Bahnhöfen, Flughäfen und Haltestellen des öffentlichen Personenverkehrs, in U-Bahn-Stationen und in Bus-Haltestellen Verwendung. Derartige Displayanordnungen umfassen in aller Regel eine Vielzahl von lichtemittierenden Elementen bzw. Leuchtpunkten, die zueinander benachbart angeordnet und individuell ansteuerbar sind. Die Darstellung von Informationen in Form von zum Beispiel frei programmierbaren Schriftzeichen und/oder Grafiken erfolgt dabei durch elektronisches Ein- und Ausschalten der Stromzuführung der jeweiligen lichtemittierenden Elemente bzw. Leuchtpunkte, so daß bei geeigneter Ansteuerung die Schriftzeichen und/oder Grafiken nachgebildet werden können. Solche Displayanordnungen besitzen allerdings den Nachteil einer geringen effektiven Leuchtfläche der angesteuerten lichtemittierenden Elemente bzw. Leuchtpunkte, wobei die dargestellten Schriftzeichen und/oder Grafiken eine pixelartige, aufgelöste Darstellung ergeben, eines geringen Kontrastes zwischen den angesteuerten und den nicht-angesteuerten lichtemittierenden Elementen bzw. Leuchtpunkten aufgrund einer starken seitlichen Abstrahlung der jeweils angesteuerten lichtemittierenden Elemente bzw. Leuchtpunkte, die in aller Regel zu einer Aufhellung der benachbarten nicht-angesteuerten Elemente führt, und eines relativ kleinen Lesewinkels für die dargestellten Schriftzeichen und/oder Graphiken.

Ausgehend vom Stand der Technik liegt der Erfindung daher die Aufgabe zugrunde, eine Displayanordnung zum Anzeigen von Informationen bereitzustellen, welche unter anderem die vorgenannten Nachteile vermindert bzw. beseitigt, mithin auf besonders einfache Weise die effektive Leuchtfläche der angesteuerten lichtemittierenden Elemente bzw. Leuchtpunkte vergrößert, den Kontrast zwischen den angesteuerten und den nicht-angesteuerten lichtemittierenden Elementen bzw. Leuchtpunkten verstärkt und den Lesewinkel für die dargestellten Schriftzeichen und/oder Graphiken vergrößert, und ein Verfahren zu deren Herstellung zur Verfügung zu stellen.

Diese Aufgabe wird in vorrichtungstechnischer Hinsicht auf überraschend einfache Weise durch die Merkmale des Anspruchs 1 gelöst.

Durch die erfindungsgemäße Ausbildung der Displayanordnung zum Anzeigen von Informationen mit einer Vielzahl von lichtemittierenden Elementen bzw. Leuchtpunkten, die zueinander benachbart angeordnet und individuell ansteuerbar sind, wobei den lichtemittierenden Elementen bzw. Leuchtpunkten wenigstens ein Element zur Vergrößerung und/oder Formgebung der von den lichtemittierenden Elementen bzw. Leuchtpunkten ausgesendeten Lichtstrahlen zugeordnet ist, läßt sich eine Displayanordnung erreichen, die konstruktiv ausgesprochen einfach und nicht zuletzt aufgrund der wenigen Bauteile sehr kompakt ausgebildet ist. Durch das wenigstens eine Element ergibt sich eine vergrößerte effektive Leuchtfläche der angesteuerten lichtemittierenden Elemente bzw. Leuchtpunkte. Durch das wenigstens eine Element wird gleichzeitig eine unerwünschte seitliche Abstrahlung der lichtemittierenden Elemente bzw. Leuchtpunkte verhindert und damit die Effizienz der Abstrahlung bzw. Flächenleuchtdichte verbessert.

Vorteilhafte konstruktive Einzelheiten der erfindungsgemäßen Displayanordnung sind in den Ansprüchen 2 bis 24 beschrieben.

In Ausgestaltung der erfindungsgemäßen Displayanordnung sind den lichtemittierenden Elementen nach Anspruch 2 Reflektoren oder dergleichen zugeordnet, so daß sich u.a. aufgrund der Reflexion an den Seiten der Reflektoren die Effizienz der Abstrahlung bzw. Flächenleuchtdichte verbessern läßt.

In diesem Zusammenhang ist es zum Erhalt einer möglichst gleichmäßigen Darstellung der anzuzeigenden Schriftzeichen und/oder Graphiken besonders vorteilhaft, die lichtemittierenden Elemente nach Anspruch 3 jeweils von dem zugeordneten Reflektor einzufassen, insbesondere in der Mitte des Reflektors anzuordnen.

Zur konstruktiven Vereinfachung sind die Reflektoren entweder an einer Loch- oder dergleichen -maske angeordnet bzw. auf einer solchen angebracht oder unmittelbar in einer Loch- oder dergleichen -maske integriert. Durch die einteilige Ausbildung von Reflektoren und Loch- oder dergleichen -maske wird die Herstellung der erfindungsgemäßen Displayanordnung noch zusätzlich erleichtert. Damit einhergehend hat dies zugleich zur Folge, daß die Herstellungskosten weiter reduziert werden können. Beispielsweise kann eine Displayanordnung nach der Erfindung mit einer Loch- oder dergleichen -maske vorgesehen sein, in der eine Vielzahl von Reflektoren, zum Beispiel im Raster von 7,62 mm oder 4,5 mm, angeordnet ist, in welchen sich jeweils ein ansteuerbares lichtemittierendes Element bzw. Leuchtpunkt befindet.

Zur Verbesserung des Reflexionsvermögens ist/sind die Reflektoren und/oder die Loch- oder dergleichen -maske aus weißem und/oder schwarzem, reflektierenden, lichtundurchlässigen Material gebildet. Als derartiges Material ist dabei vorzugsweise Kunststoff vorgesehen.

Um einen vergrößerten und/oder gegebenenfalls mit einer bestimmten Form versehenen Leuchtpunkt durch die Lichtstrahlen des jeweiligen lichtemittierenden Elementes darzustellen, können den lichtemittierenden Elemente nach Anspruch 4 auch Linsen, insbesondere Sammellinsen, oder dergleichen zugeordnet sein.

Diesbezüglich liegt es insbesondere im Rahmen der Erfindung, daß die lichtemittierenden Elemente nach Anspruch 5 jeweils von der zugeordneten Linse, welche vorzugsweise mittig ausgerichtet ist, über- bzw. abgedeckt sind. Das jeweilige lichtemittierende Element befindet sich dabei vornehmlich vollständig unterhalb der zugeordneten Linse. Es ist allerdings ebenso denkbar, daß die Linse und das zugeordnete lichtemittierende Element nur teil- bzw. abschnittsweise in gegenseitige Überdeckung gebracht sind.

Nach einem weiteren Merkmal der erfindungsgemäßen Displayanordnung bestehen die Linsen vorzugsweise aus optisch transparentem Kunststoff, insbesondere aus Silikon.

In vorteilhafter Weise werden die Linsen, zum Beispiel mit Hilfe der Siebdruck- oder Dosiertechnik bzw. einer sonstigen Beschichtungstechnik, rückseitig auf einer Lage, Schicht oder dergleichen, die sie trägt, aufgebracht, welche den lichtemittierenden Elementen zugeordnet ist. Die Linsen sind dabei insbesondere den lichtemittierenden Elementen zugewandt.

Darüber hinaus ist es von besonderem Interesse für eine verbesserte Formgebung der von den lichtemittierenden Elementen ausgesendeten Lichtstrahlen, entsprechend den Merkmalen des Anspruchs 6, Elemente oder dergleichen zur Abschirmung, wie zum Beispiel zur Absorption oder Reflexion, von seitlichen Lichtstrahlen vorzusehen, die den lichtemittierenden Elementen zugeordnet sind. Diese Elemente zur Abschirmung können voneinander jeweils separiert oder ebenso in Form einer Lage, Schicht oder dergleichen miteinander zusammenhängend ausgebildet sein.

Durch die erfindungsgemäße Ausbildung der Displayanordnung nach Anspruch 7, daß nämlich die lichtemittierenden Elemente jeweils von dem zugeordneten lichtabschirmenden Element eingefaßt und insbesondere in der Mitte des lichtabschirmenden Elementes angeordnet sind, läßt sich auf einfache Weise jegliche seitliche Abstrahlung der jeweiligen angesteuerten lichtemittierenden Elemente zu benachbarten, eventuell nicht-angesteuerten lichtemittierenden Elementen unterbinden. Die Folge davon ist eine Verhinderung der unerwünschten Aufhellung von benachbarten lichtemittierenden Elementen und damit eine Kontrastverschärfung.

Als zweckmäßig hat sich in diesem Zusammenhang herausgestellt, daß die lichtabschirmenden Elemente als Folie, Platte, scheibenförmiges Element oder dergleichen ausgebildet sind, die vorzugsweise aus einer lichtundurchlässigen, ein- oder mehrschichtigen Gitterstruktur bestehen. Auch eine solche Gitterstruktur läßt sich heutzutage besonders kostengünstig, beispielsweise mittels Siebdrucktechnik, herstellen.

Weiterhin liegt es alternativ oder kumulativ zu den vorhergehenden Maßnahmen nach Anspruch 8 noch im Rahmen der Erfindung, den lichtemittierenden Elementen eine Lage, Schicht oder dergleichen zur selektiven Filterung von Lichtstrahlen zuzuordnen, die vorteilhafterweise eine Filtercharakteristik aufweist, welche auf die Wellenlänge der von den lichtemittierenden Elementen ausgesendeten Lichtstrahlen abgestimmt ist.

Nach Anspruch 9 ist die lichtfilternde Lage, Schicht oder dergleichen als Folie, Platte, scheibenförmiges Element oder dergleichen ausgebildet. So läßt sich die lichtfilternde Lage, Schicht oder dergleichen zum Beispiel durch eine Scheibe aus Glas oder Kunststoff realisieren, in der lichtfilternde (Farb-) Pigmente oder ähnliches integriert sind, welche schon bei der Herstellung der Scheibe in diese mit eingeschmolzen bzw. eingebunden werden.

Alternativ dazu kann die lichtfilternde Lage, Schicht oder dergleichen jedoch ebenso nur abschnittsweise in den Bereichen oberhalb der lichtemittierenden Elemente vorgesehen sein.

Dabei ist nach den Maßnahmen des Anspruchs 10 als lichtfilternde Lage, Schicht oder dergleichen ein Farbauftrag vorgesehen, der als selektiver Filter wirkt, wodurch eine vereinfachte Herstellung, zum Beispiel mit der Siebdrucktechnik, ermöglicht wird. Ein solcher Farbauftrag kann zum Beispiel an einer eigens zu dessen Aufnahme vorgesehenen tragenden bzw. abstützenden Lage, Schicht oder dergleichen oder ebenso an der die Linsen aufnehmenden Lage, Schicht oder dergleichen angebracht sein.

Von ganz besonders großer Bedeutung für eine ausgesprochen einfache, kompakte und zugleich kostengünstige Bauweise sowie eine gleichzeitig weitergehende Verbesserung bzw. Vergrößerung des Lesewinkels und eine gleichmäßige Verteilung der Leuchtdichte der einzelnen lichtemittierenden Elemente bzw. Leuchtpunkte sind die Maßnahmen des Anspruchs 11, wonach den lichtemittierenden Elementen bzw. Leuchtpunkten eine Lage, Schicht oder dergleichen mit Streuwirkung zugeordnet ist, welche die im wesentlichen parallele Ausrichtung der (reflektierten) Lichtstrahlen in eine streuende, mehr nach allen Richtungen gehende (diffuse) Lichtabstrahlung ändert.

In diesem Zusammenhang ist erfindungsgemäß vorgesehen, daß die lichtstreuende Lage, Schicht oder dergleichen nach Anspruch 12 als Folie, Platte, scheibenförmiges Element oder dergleichen ausgebildet ist. Eine solche Ausgestaltung ermöglicht eine einfache, zugleich aber sehr kostengünstige Herstellungsweise. Als Material für eine solche lichtstreuende Lage, Schicht oder dergleichen ist vorzugsweise Kunststoff oder (glas-)faserverstärkter Kunststoff vorgesehen. Es ist jedoch ebenso denkbar, als Material Glas einzusetzen. Dies hat den zusätzlichen Vorteil, daß unter Umständen das Gehäuse bzw. ein Teil des Gehäuses der gesamten Displayanordnung oder lediglich der lichtemittierenden Elemente in Form einer Glasscheibe unmittelbar als lichtstreuende Lage, Schicht oder dergleichen eingesetzt werden kann.

In aller Regel ist die lichtstreuende Lage, Schicht oder dergleichen vorteilhafterweise oberhalb der lichtemittierenden Elemente auf den Reflektoren und/oder auf den Linsen und/oder auf der tragenden Lage, Schicht oder dergleichen und/oder auf den lichtabschirmenden Elementen und/oder der lichtfilternden Lage, Schicht oder dergleichen, aufgesetzt, beispielsweise aufgeklebt.

Zweckmäßigerweise ist/sind die lichtfilternde Lage, Schicht oder dergleichen und/oder die lichtstreuende Lage, Schicht oder dergleichen nach Anspruch 13 als Lage, Schicht oder dergleichen zum Tragen bzw. zur Abstützung der Linsen bzw. unter Umständen auch der lichtabschirmenden Elemente vorgesehen.

Nach Anspruch 14 können die lichtemittierenden Elemente selbst bei der erfindungsgemäßen Displayanordnung als alternative, vorteilhafte Ausgestaltung auch wenigstens teilweise eine Oberfläche zur Streuung der Lichtstrahlen aufweisen.

Dabei stellen insbesondere die konstruktiven Maßnahmen nach Anspruch 15 und 16 im Hinblick auf eine vereinfachte und kostengünstige Herstellung einen weiteren Vorteil der erfindungsgemäßen Displayanordnung dar. Demnach weisen die lichtemittierenden Elemente jeweils ein Gehäuse, einen Körper oder dergleichen auf, das bzw. der aus Kunststoffen und Harzen bzw. Resinen, vornehmlich aus Epoxidharzen, besteht. Dessen lichtstreuende Oberfläche ist mittels Bestrahlen durch (Mikro-)Glasperlen etc., durch Anätzen im Tauchverfahren oder Anätzen mit Ätzfolien gebildet. Die lichtstreuende Oberfläche kann dabei gesondert hergestellt werden. Alternativ ist es jedoch ebenso denkbar, die lichtstreuende Oberfläche durch entsprechende (Vor-)Behandlung der Gieß- bzw. Spritzgußformen, die für die Erzeugung der lichtemittierenden Elemente verwendet werden, herzustellen. In letzterem Fall übernimmt beispielsweise die Oberfläche des Gehäuses oder Körpers des lichtemittierenden Elementes die Streuung des abgestrahlten Lichtes. Dies kann vorteilhaft in Außenbereichen genutzt werden, wenn die lichtstreuende Lage, Schicht oder dergleichen wegen eines erhöhten Leuchtdichtebedarfs nur begrenzt einsetzbar ist.

In einer noch anderen Ausgestaltung der Erfindung können die lichtemittierenden Elemente nach den Merkmalen des Anspruchs 17 auch eine Form oder wenigstens einen Abschnitt aufweisen, die bzw. der eine lichtstreuende Wirkung ermöglicht. So ist es denkbar, daß die lichtemittierenden Elemente selbst jeweils als Streulinsen ausgebildet sind. Beispielsweise ist es möglich, daß die lichtemittierenden Elemente die Form eines Kegels, einer Pyramide oder sonstigen Polygons annehmen oder zumindest mit einem kegel-, pyramiden- oder dergleichen -förmigen oder sonstwie polygonartigen Kopf bzw. Aufsatz versehen sind, wodurch sich eine Änderung der im wesentlichen parallelen Ausrichtung der Lichtstrahlen in eine nach allen Richtungen verteilte (diffuse) Abstrahlung der (reflektierten) Lichtstrahlen erreichen läßt.

Von weiterem wesentlichen Vorteil der erfindungsgemäßen Displayanordnung sind die konstruktiven Maßnahmen nach Anspruch 18, wonach Bereiche zwischen einander benachbarten Reflektoren, d.h. außerhalb der wirksamen Reflektorbereiche, eine lichtkontrastverstärkende Oberfläche aufweisen. Die Erhöhung des Kontrastes zwischen den angesteuerten und den nicht-angesteuerten lichtemittierenden Elementen bzw. Leuchtpunkten hat eine wesentlich konturenschärfere Darstellung der Schriftzeichen und/oder Graphiken zur Folge.

Dabei liegt es im Rahmen der Erfindung, den Bereichen zwischen einander benachbarten Reflektoren eine Lage, Schicht oder dergleichen zuzuordnen, die eine Verstärkung des Lichtkontrastes nach sich zieht. Hierdurch ist eine besonders einfache und zudem kostengünstige Herstellung der erfindungsgemäßen Displayanordnung bei gleichzeitig erhöhtem Kontrastvermögen sichergestellt.

In diesem Zusammenhang ist die lichtkontrastverstärkende Lage, Schicht oder dergleichen nach Anspruch 19 als Folie, Platte, scheibenförmiges Element oder dergleichen ausgebildet, die in den wirksamen Bereichen der Reflektoren mit Ausnehmungen oder Aussparungen versehen ist. Als Material für eine derartige Lage, Schicht oder dergleichen, bietet sich dabei in vorteilhafter Weise Kunststoff, (glas-)faserverstärkter Kunststoff oder sogar Glas an.

Weiterhin ist erfindungsgemäß vorgesehen, die lichtkontrastverstärkende Lage, Schicht oder dergleichen dunkel, insbesondere schwarz, matt, matt-glänzend oder strukturiert auszubilden. Die Displayanordnung nach der Erfindung läßt sich auf diese Weise einfach, kostengünstig und individuell an beliebig anzutreffende Lichtverhältnisse und/oder Kundenwünsche anpassen.

Vorzugsweise ist die lichtkontrastverstärkende Lage, Schicht oder dergleichen nach Anspruch 20 in den Bereichen zwischen einander benachbarten Reflektoren, beispielsweise durch Klebung, angebracht. In diesem Zusammenhang ist es möglich, die lichtkontrastverstärkende Lage, Schicht oder dergleichen erfindungsgemäß auf den Reflektoren und/oder der Loch- oder dergleichen -maske bzw. in alternativer Ausgestaltung auf der lichtstreuenden Lage, Schicht oder dergleichen anzuordnen.

Weiterhin liegt es im Rahmen der Erfindung, daß die Reflektoren und/oder die Linsen und/oder die lichtabschirmenden Elemente und/oder die lichtfilternde Lage, Schicht oder dergleichen und/oder die lichtstreuende Lage, Schicht oder dergleichen und/oder die lichtkontrastverstärkende Lage, Schicht oder dergleichen nach Anspruch 21 derart ausgebildet ist/sind, daß die erzeugten Bilder bzw. Leuchtpunkte in der Projektions- bzw. Bildebene eine kreisförmige, ellipsoide, dreieckige, viereckige oder sonstwie polygonale, wie zum Beispiel achteckige, Form aufweisen. Auf diese Weise ist es möglich, die Anzeigefläche insgesamt ohne großen Aufwand an einsatz- oder kundenspezifische Vorgaben individuell anzupassen.

Vorzugsweise sind die lichtemittierenden Elemente bzw. Leuchtpunkte nach Anspruch 22 als Dioden, zum Beispiel als ein- oder mehrfarbige Leuchtdioden, ausgebildet. Entsprechend den jeweils vorhandenen baulichen Gegebenheiten, wie Bauhöhe oder dergleichen, und sonstigen konstruktiven Vorgaben können die lichtemittierenden Elemente bzw. Leuchtpunkte dabei in Form von LED-Elementen mit (Draht-)Anschlüssen, in Form von oberflächenmontierbaren LED-Elementen, sogenannten SMD (surface mounted device)-LED-Elementen etc. ausgestaltet sein.

Durch die konstruktiven Maßnahmen nach Anspruch 23, daß die lichtemittierenden Elemente zueinander in Form einer Matrix oder dergleichen angeordnet sind, die insbesondere mit weiteren Matrizen aus lichtemittierenden Elementen eine Fläche zum Anzeigen der Informationen bilden, lassen sich auf ausgesprochen einfache Weise beliebige, einsatzspezifische Anzeigeflächen erhalten. So ist es beispielsweise möglich, frei käufliche bedrahtete lichtemittierende Elemente bzw. Leuchtpunkte in Form von sogenannten LED-Einzelelementen zu einer Matrix aus zum Beispiel 24 x 48 oder 32 x 48 lichtemittierenden Elementen zusammenzusetzen. Eine solche Matrix kann dann beispielhaft 1152 lichtemittierende Elemente bzw. Leuchtpunkte aufweisen. Durch Aneinanderreihung mehrerer, zum Beispiel 6 bis 8, Matrizen ergibt sich dann eine Anzeigefläche, die ausreichend ist, um Informationen, wie Schriftzeichen und/oder Graphiken groß und deutlich genug darzustellen.

Des weiteren eignet sich die erfindungsgemäße Displayanordnung nach Anspruch 24 besonders gut für eine Verwendung in einem Land- und/oder Luft- und/oder Wasserfahrzeug, insbesondere in einem Schienenfahrzeug, Flugzeug, Raumschiff, Schiff oder dergleichen, das entweder für eine Beförderung von Personen und/oder für einen Transport von sonstigen Lebewesen oder Gegenständen vorgesehen ist. Ebenso ist es jedoch auch denkbar, die erfindungsgemäße Displayanordnung in einem stationären System, beispielsweise im Bereich von Bahnhöfen, Flughäfen oder Haltestellen des öffentlichen Personennahverkehrs, wie etwa in U-Bahn-Stationen und an Bushaltestellen, oder auch in einem Regalsystem von Einkaufsmärkten, Lagerhäusern etc. zu benutzen.

Diese Aufgabe wird darüber hinaus in verfahrenstechnischer Hinsicht durch die Merkmale des Anspruchs 25 gelöst.

Durch die erfindungsgemäßen Mikrostrukturtechniken zur Herstellung einer Displayanordnung zum Anzeigen von Informationen mit einer Vielzahl von lichtemittierenden Elementen, die zueinander benachbart angeordnet und individuell ansteuerbar sind, insbesondere unter Ausnutzung moderner Druck-, Beschichtungs- und Dosiertechniken sowie Tauch-, Ätz-, Strahl- oder Gießtechniken, lassen sich eine Verbesserung des Kontrastes, eine Vergrößerung der Leuchtpunkte und eine Anhebung der Leuchtdichte erreichen. Die Abstrahlung der Information erfolgt in einem fast halbraumförmigen Sicht- bzw. Lesewinkel mit maximal möglicher und weitgehend einheitlicher Intensität, insbesondere deshalb, weil die Mikrostrukturen auf vor allem der lichtstreuenden Lage, Schicht der dergleichen mit vergleichsweise sehr kleinen Schichtdicken realisierbar sind. Auf diese Weise können die lichtemittierenden Elemente entsprechend nah an diese lichtstreuende Lage, Schicht oder dergleichen plaziert werden. Die Mikrostrukturen bilden mit der insbesondere lichtstreuenden Lage, Schicht oder dergleichen eine integrierte Baueinheit, welche sich leicht und präzise fertigen sowie montieren läßt.

Darüber hinaus lassen sich eine Vergrößerung des Abstrahlwinkels der Leuchtdioden und damit einhergehend eine Verbesserung der Abstrahlcharakteristik insgesamt erreichen, indem die Oberflächen der Leuchtdioden speziell behandelt bzw. geformt sind, so daß das emittierte Licht im wesentlichen nur an der Oberfläche gestreut wird. Es ergibt sich insoweit eine deutlich höhere Leuchtdichte. Die auf diese Weise hergestellte Displayanordnung weist miteinander verbundene flache Bauteile auf, die gegenüber der üblichen Vielzahl von Bauteilen präziser gefertigt, leichter handhabbar und herstellbar sind. In der Summe ergibt sich ein flacheres, preisgünstigeres Produkt hoher Qualität mit erweitertem Einsatzbereich, da Kontrast, Leuchtdichte, Lichtpunktgröße und Sicht(-lese-)winkel steigen.

Weitere Merkmale, Vorteile und Einzelheiten der Erfindung ergeben sich aus der nachfolgenden Beschreibung bevorzugter Ausführungsformen der Erfindung sowie anhand der Zeichnungen. Hierbei zeigen:
- Fig. 1: eine teilweise abgebrochene, schematische Schnittansicht durch eine Ausführungsform einer erfindungsgemäßen Displayanordnung mit zwei lichtemittierenden Elementen bzw. Leuchtpunkten und dazugehörigen Bildern bzw. Leuchtpunkten in der Projektions- bzw. Bildebene,
- Fig. 2: eine teilweise abgebrochene, schematische Schnittansicht durch eine andere Ausführungsform einer erfindungsgemäßen Displayanordnung mit einem lichtemittierenden Element bzw. Leuchtpunkt und dazugehörigem Bild bzw. Leuchtpunkt in der Projektionsebene entsprechend Fig. 1,
- Fig. 3: eine teilweise abgebrochene, schematische Schnittansicht durch eine noch andere Ausführungsform einer erfindungsgemäßen Displayanordnung mit zwei lichtemittierenden Elementen bzw. Leuchtpunkten und dazugehörigen Bildern bzw. Leuchtpunkten in der Projektionsebene entsprechend Fig. 1,
- Fig. 4a, 4b und 4c: schematische Draufsichten auf verschiedene Ausführungsformen einer erfindungsgemäßen Displayanordnung mit einer Matrix zur Darstellung eines Buchstabens,
- Fig. 5: eine teilweise abgebrochene, schematische Schnittansicht durch eine weitere Ausführungsform einer erfindungsgemäßen Displayanordnung mit einem lichtemittierenden Element bzw. Leuchtpunkt und dazugehörigem Bild bzw. Leuchtpunkt in der Projektions- bzw. Bildebene entsprechend Fig. 1,
- Fig. 6: eine teilweise abgebrochene, schematische Schnittansicht durch eine Ausführungsform einer erfindungsgemäßen Displayanordnung mit zwei lichtemittierenden Elementen bzw. Leuchtpunkten und dazugehörigem Bildern bzw. Leuchtpunkten in der Projektionsebene entsprechend Fig. 1,
- Fig. 7: eine teilweise abgebrochene, schematische Schnittansicht durch eine andere Ausführungsform einer erfindungsgemäßen Displayanordnung mit zwei lichtemittierenden Elementen bzw. Leuchtpunkten und dazugehörigen Bildern bzw. Leuchtpunkten in der Projektionsebene entsprechend Fig. 1,
- Fig. 8: eine teilweise abgebrochene, schematische Schnittansicht durch eine noch andere Variante einer erfindungsgemäßen Displayanordnung mit drei lichtemittierenden Elementen bzw. Leuchtpunkten und dazugehörigen Bildern bzw. Leuchtpunkten in der Projektionsebene entsprechend Fig. 1,
- Fig. 9: eine teilweise abgebrochene schematische Draufsicht auf eine Vielzahl von zueinander in Form einer Matrix angeordneten, lichtemittierenden Elementen entsprechend Ausschnitt IX in der Fig. 10, und
- Fig. 10: eine Draufsicht auf eine Fläche zum Anzeigen der Informationen mit einer Vielzahl von lichtemittierenden Elementen, die in vielen Matrizen angeordnet sind, in verkleinerter Darstellung.

Bei der nachfolgenden Beschreibung von verschiedenen Ausführungsbeispielen erfindungsgemäßer Displayanordnungen 10 sind einander entsprechende, gleiche Bauteile jeweils mit identischen Bezugsziffern versehen.

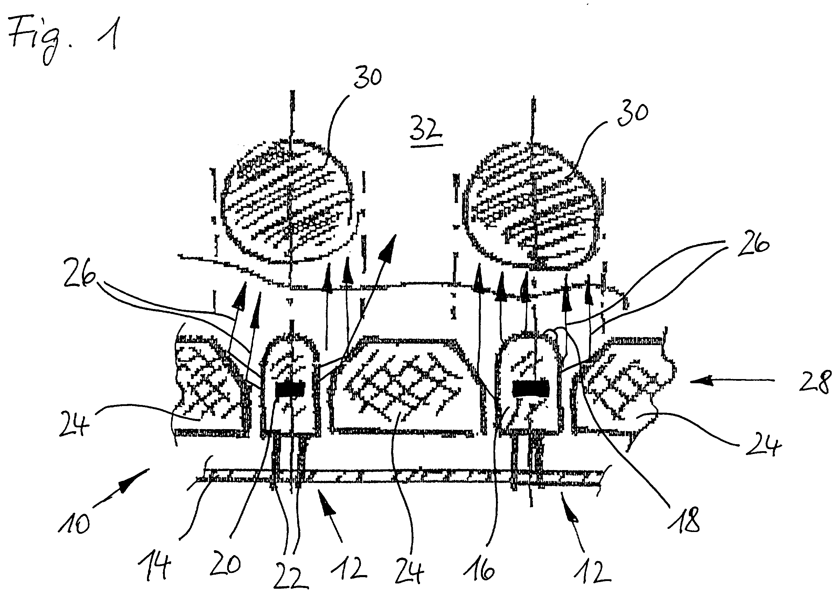

In der Fig. 1 ist auf schematische Weise eine Ausführungsform einer erfindungsgemäßen Displayanordnung 10 zum Anzeigen von Informationen dargestellt. Die Displayanordnung 10 nach der Erfindung eignet sich besonders zur Verwendung in einem Land- und/oder Luft- und/oder Wasserfahrzeug, insbesondere in einem Schienenfahrzeug, Flugzeug, Schiff oder sogar Raumschiff zur Beförderung von Personen, wie beispielsweise in Eisenbahnwaggons zur Platzreservierung, und/oder zum Transport von sonstigen Lebewesen und Gegenständen mit individuellen Merkmalen, wie zum Beispiel Herkunftsort, Transportweg, Bestimmungsort etc. Darüber hinaus eignet sich die erfindungsgemäße Displayanordnung aber ebenso zur Verwendung in einem stationären System, wie zum Beispiel im Bereich von Bahnhöfen und Haltestellen des öffentlichen Personennahverkehrs, wie etwa U-Bahn-Stationen oder Bushaltestellen, sowie in einem Regalsystem von Einkaufsmärkten, Lagerhäusern etc.

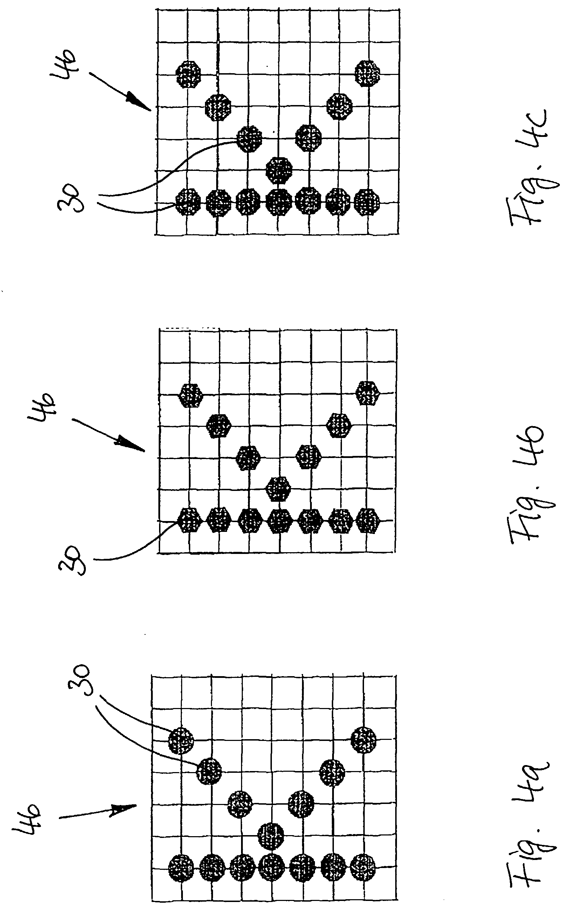

Die in der Fig. 1 dargestellte Displayanordnung umfaßt eine Vielzahl von lichtemittierenden Elementen 12, die zueinander benachbart, vorzugsweise in Form einer Matrix oder dergleichen (vgl. Fig. 4a bis 4c) angeordnet sind. Eine solche Matrix wiederum bildet insbesondere mit weiteren Matrizen aus lichtemittierenden Elementen 12 eine gesamte (vgl. Fig. 10) Fläche zum Anzeigen der Informationen, wie Schriftzeichen und/oder Graphiken.

In der Fig. 1 sind zur besseren Übersicht lediglich zwei baugleiche lichtemittierende Elemente 12 der Displayanordnung 10 nach der Erfindung dargestellt. Die lichtemittierenden Elemente 12 der Fig. 1 sind als Dioden, beispielsweise als LED-Elemente, ausgebildet. Dabei sind die lichtemittierenden Elemente 12 auf an sich bekannte Weise an einer Leiterplatte 14 angeordnet und umfassen jeweils ein Gehäuse 16 bzw. einen Körper oder dergleichen mit einer (äußeren) Oberfläche 18, das bzw. der aus Kunststoffen oder Harzen bzw. Resinen, wie zum Beispiel Epoxidharzen, besteht. In die Gehäuse 16, Körper oder dergleichen ist jeweils ein Halbleiterbauelement bzw. Chip 20 eingebettet bzw. eingegossen. Die Halbleiterbauelemente bzw. Chips bzw. Dies 20 der lichtemittierenden Elemente 12 wiederum sind über (Draht-) Anschlüsse 22 und Leiter(-bahnen) an bzw. auf bzw. in der Leiterplatte 14 (nicht dargestellt) von außen mit Strom versorgbar.

Zur Darstellung der Informationen, d.h. Zeichen und/oder Graphiken, werden die lichtemittierenden Elemente 12 individuell durch elektronisches Ein- und Ausschalten der jeweiligen Stromzuführung angesteuert bzw. nicht-angesteuert. Die lichtemittierenden Elemente 12 wirken bei gleichzeitiger, geeigneter und vorbestimmter Ansteuerung zusammen und bilden die Darstellung der anzuzeigenden Informationen, d.h. Schriftzeichen und/oder Graphiken.

Den lichtemittierenden Elementen 12 der erfindungsgemäßen Displayanordnung 10 sind Elemente in Form von Reflektoren 24 oder dergleichen zugeordnet, um deren lichtreflektierenden Flächen, welche von den lichtemittierenden Elementen 12 angestrahlt werden, zur Vergrößerung der Leuchtpunkte zu nutzen und/oder ihnen gegebenenfalls eine besondere Form zu verleihen.

Zu diesem Zweck sind die lichtemittierenden Elemente 12 jeweils von dem zugeordneten Reflektor 24 eingefaßt. Bei der in der Fig. 1 dargestellten Ausführungsform der erfindungsgemäßen Displayanordnung 10 sind die lichtemittierenden Elemente 12 dabei jeweils etwa mittig zum Reflektor 24 angeordnet.

Die Reflektoren 24 sind vorzugsweise in einer Loch- oder dergleichen -maske 28 integriert. Mithin sind die Reflektoren 24 und die Loch- oder dergleichen -maske 28 einteilig ausgebildet. Demgegenüber ist eine zweiteilige Ausgestaltung der Reflektoren 24 und der Loch- oder dergleichen -maske 28 ebenso möglich (nicht dargestellt). In diesem Fall wären die Reflektoren 24 an bzw. auf einer Loch- oder dergleichen -maske 28 angeordnet bzw. aufgebracht.

In vorteilhafter Weise ist/sind die Reflektoren 24 und/oder die Loch- oder dergleichen -maske 28 aus Material, wie insbesondere Kunststoff, gebildet, das weiß und/oder schwarz ist, ein gutes Reflexionsvermögen aufweist und insbesondere gegenüber Lichtstrahlen 26 von den lichtemittierenden Elementen 12 (teilweise) undurchlässig ist.

Durch die Form der Reflektoren 24 ergibt sich jeweils eine Vergrößerung der effektiven Leuchtfläche des lichtemittierenden Elementes 12 bzw. des von diesem erzeugten Leuchtpunktes 30 in der Projektions- bzw. Bildebene 32. Die Leuchtpunkte 30 der Projektions- bzw. Bildebene 32 sind in den Figuren schematisch von vorne, im Nahsichtbereich und mit einem Betrachtungswinkel von 0° gezeigt.

Die Leuchtpunkte 30 in der Projektionsebene 32 sind bei der in der Fig. 1 dargestellten Ausführungsform der erfindungsgemäßen Displayanordnung 10 kreisförmig ausgebildet und um nahezu den Faktor 2 vergrößert. So ließen sich in der Praxis beispielsweise von einer herkömmlichen Displayanordnung erzeugte Leuchtpunkte mit einem Kreisdurchmesser von 5 mm mittels der Displayanordnung 10 nach der Erfindung auf einen Kreisdurchmesser von zum Beispiel 7 mm vergrößern. Gleichzeitig wird eine unerwünschte seitliche Abstrahlung der lichtemittierenden Elemente 12 verhindert und die Effizienz der Abstrahlung bzw. Flächenleuchtdichte verbessert.

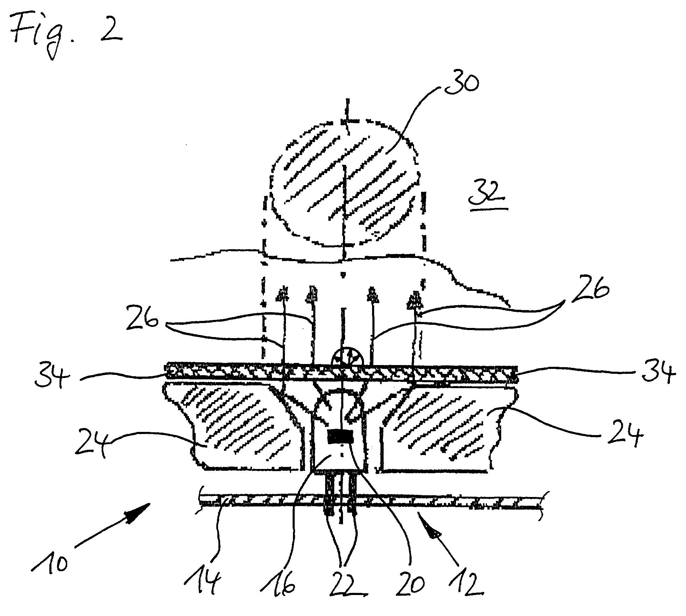

In der Fig. 2 ist ein weiteres Ausführungsbeispiel einer Displayanordnung 10 nach der Erfindung dargestellt. Abgesehen von der Tatsache, daß bei der weiteren Ausführungsform einer erfindungsgemäß ausgebildeten Displayanordnung 10 nach der Fig. 2 lediglich ein lichtemittierendes Element 12 dargestellt ist, unterscheidet sich die Ausführungsform der erfindungsgemäßen Displayanordnung 10 nach der Fig. 2 von der derjenigen nach der Fig. 1 lediglich durch ein zusätzliches Element zur Vergrößerung und/oder Formgebung. Dieses Element ist aus einer Lage 34, Schicht oder dergleichen mit lichtstreuender Wirkung gebildet. Die lichtstreuende Lage 34, Schicht oder dergleichen ist den lichtemittierenden Elementen 12 zugeordnet, um eine vorzugsweise nach allen Richtungen verteilte (diffuse) Abstrahlung der reflektierten Lichtstrahlen 26 zu erreichen.

Die lichtstreuende Lage 34, Schicht oder dergleichen ist in vorteilhafter Weise als Folie, Platte, scheibenförmiges Element oder dergleichen ausgebildet und besteht insbesondere aus Kunststoff, (glas-)faserverstärktem Kunststoff oder Glas.

Wie aus dem Ausführungsbeispiel der Fig. 2 deutlich hervorgeht, ist die lichtstreuende Lage 34, Schicht oder dergleichen auf den Reflektoren 24 angebracht, insbesondere aufgeklebt, derart, daß die lichtemittierenden Elemente 12 vollständig über- bzw. abgedeckt sind.

Durch das Aufbringen bzw. Aufkleben einer derart stark lichtstreuenden Lage 34, Schicht oder dergleichen in Form einer Folie über dem jeweiligen lichtemittierenden Element 12 bzw. Leuchtpunkt ergibt sich auf einfache, kostengünstige und wirksame Weise eine erhebliche Verbesserung bzw. Vergrößerung des Lesewinkels und eine gleichmäßige Verteilung der Leuchtdichte der einzelnen Leuchtpunkte 30 in der Projektionsebene 32.

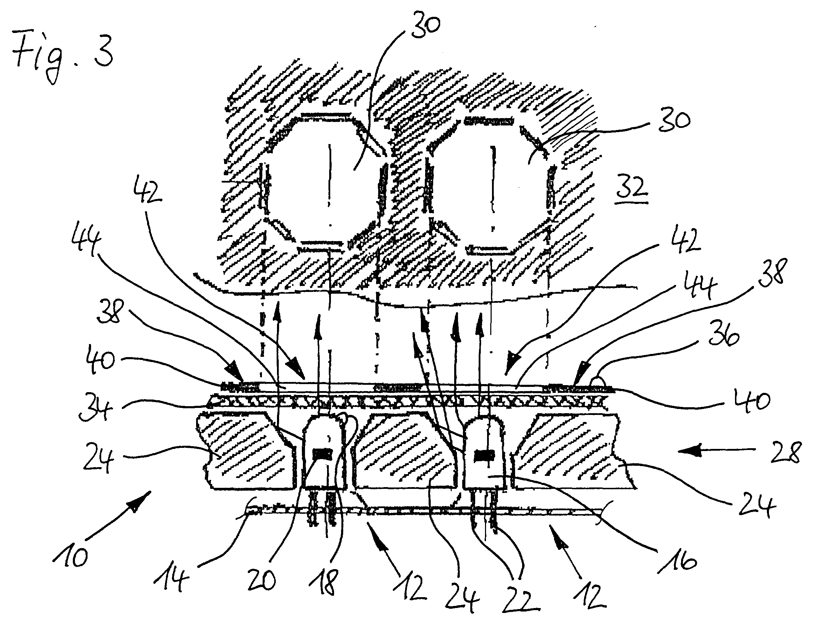

Des weiteren ist in der Fig. 3 eine noch andere Ausführungsform einer erfindungsgemäßen Displayanordnung 10 gezeigt. Diese unterscheidet sich von den beiden vorhergehenden Ausführungsformen der Displayanordnung 10 nach den Fig. 1 und 2 durch ein weiteres Element zur Vergrößerung und/oder Formgebung, das in Form einer lichtkontrastverstärkenden Oberfläche 36 in den Bereichen 38 zwischen einander benachbarten Reflektoren 24 vorgesehen ist.

Den Bereichen 38, zwischen den einander benachbarten Reflektoren 24, ist vorzugsweise eine Lage 40, Schicht oder dergleichen zur Verstärkung des Lichtkontrastes zugeordnet.

Die lichtkontrastverstärkende Lage 40, Schicht oder dergleichen ist dabei als Folie, Platte, scheibenförmiges Element oder dergleichen ausgebildet und besteht insbesondere aus Kunststoff, (glas-)faserverstärktem Kunststoff oder Glas. Um den Durchgang der Lichtstrahlen 26 von dem lichtemittierenden Element 12 und/oder den Reflektoren 24 über die lichtstreuende Lage 34, Schicht oder dergleichen auf die Projektionsebene 32 sicherzustellen bzw. nicht einzuschränken, ist die lichtkontrastverstärkende Lage 40, Schicht oder dergleichen dabei in den wirksamen Bereichen 42 der Reflektoren 24 mit Ausnehmungen 44 oder Aussparungen versehen.

Die lichtkontrastverstärkende Lage 40, Schicht oder dergleichen ist in diesem Zusammenhang vorzugsweise dunkel, insbesondere schwarz, matt, matt glänzend oder strukturiert ausgebildet. Nach einer bevorzugten Ausführungsform ist die lichtkontrastverstärkende Lage 40, Schicht oder dergleichen in den Bereichen 38 zwischen einander benachbarten Reflektoren 24 angebracht, und zwar beispielsweise durch Aufkleben. Dabei ist es möglich, die lichtkontrastverstärkende Lage 40, Schicht oder dergleichen unmittelbar auf der lichtstreuenden Lage 34, Schicht oder dergleichen, wenn eine solche bei der Displayanordnung 10 nach der Erfindung vorhanden ist, aufzutragen.

In alternativer oder kumulativer Ausgestaltung ist es jedoch ebenso denkbar, die lichtkontrastverstärkende Lage 40, Schicht oder dergleichen unmittelbar auf den Reflektoren 24 und/oder Loch- oder dergleichen -maske 28 aufzutragen und an dieser zu befestigen (nicht dargestellt).

Entsprechend dem Ausführungsbeispiel der erfindungsgemäßen Displayanordnung 10 nach der Fig. 3 sind die Reflektoren 24 derart ausgebildet, daß die in der Projektionsebene 32 erzeugten Leuchtpunkte 30 bzw. Bilder nicht kreisförmig, wie in den Ausführungsformen der Displayanordnung 10, welche in den Fig. 1 und 2 dargestellt sind, sondern polygonal, d.h. hier achteckig, sind.

Durch das Aufbringen einer zum Beispiel schwarzen bzw. matten Oberfläche 36 außerhalb der wirksamen Reflektorbereiche 42 ergibt sich eine wesentliche Erhöhung des Kontrastes zwischen den angesteuerten und den nicht-angesteuerten lichtemittierenden Elementen 12 bzw. Leuchtpunkten 30 in der Projektionsebene 32.

Ohne im einzelnen dargestellt zu sein, kann/können die lichtstreuende Lage 34, Schicht oder dergleichen und/oder die lichtkontrastverstärkende Lage 40, Schicht oder dergleichen mittels Bestrahlen durch Glasperlen, Anätzen durch Tauchverfahren oder Anätzen durch Ätzfolien etc. hergestellt werden. Ebenso ist es denkbar, diese im Fall einer Folie oder Platte aus Kunststoffmaterial zum Beispiel durch Einmischen von opazitätssteigernden Substanzen oder durch Strukturierung mittels (Ein-)Prägung von Rillen, Rastern, Netzen oder sonstigen Mustern zu erhalten.

Nach den Fig. 4a, 4b und 4c ist es möglich, die Reflektoren 24 derart auszubilden, daß die in der Projektionsebene 32 erzeugten Leuchtpunkte 30 zum Beispiel die Form eines vergrößerten Kreises, entsprechend den beiden Ausführungsformen der erfindungsgemäßen Displayanordnung 10 nach den Fig. 1 und 2, oder eines Polygons in Form eines Achtecks, entsprechend der Ausführungsform der erfindungsgemäßen Displayanordnung 10 nach der Fig. 3, annehmen. Ebenso ist es möglich, daß die in der Projektionsebene 32 erzeugten Leuchtpunkte 30 durch entsprechende Ausgestaltung der Reflektoren 24 und/oder der lichtstreuenden Lage 34, Schicht oder dergleichen und/oder der lichtkontrastverstärkenden Lage 40, Schicht oder dergleichen eine dreieckige, viereckige - sei es eine quadratische bzw. rechteckige - oder sonstwie polygonale oder jede denkbar andere Form erhalten.

Demnach wird beispielsweise durch Aktivierung bzw. Stromzuführung von insgesamt 22 lichtemittierenden Elementen 12, die zueinander in Form einer Matrix 46 oder dergleichen angeordnet sind, der Buchstabe K angezeigt. Dabei sind die Leuchtpunkte 30 in der Projektionsebene 32 für den Betrachter bei der Ausführungsform der Matrix 46 nach der Fig. 4a kreisförmig, nach der Fig. 4b sechseckig und nach der Fig. 4c achteckig gehalten.

Des weiteren ist es möglich, daß die lichtemittierenden Elemente 12 unmittelbar selbst wenigstens teilweise mit einer Oberfläche zur Streuung der Lichtstrahlen 26 versehen werden (nicht gezeigt). Auf eine gesonderte lichtstreuende Lage 34, Schicht oder dergleichen kann in diesem Fall verzichtet werden.

Für Anwendungen der erfindungsgemäßen Displayanordnung 10 in Außenbereichen zum Beispiel, in welchen ein Einsatz der insbesondere lichtstreuenden Lage 34, Schicht oder dergleichen aufgrund eines sehr hohen Bedarfs an Leuchtdichte nur begrenzt möglich ist, kann nämlich die Oberfläche 18 der lichtemittierenden Elemente 12, d.h. diejenige von deren Gehäusen 16, Körpern oder dergleichen, selbst die Funktion der Projektionsebene 32 übernehmen. Die Streuwirkung der Oberfläche 18 des Gehäuses bzw. Körpers 16 kann durch entsprechende Behandlung der Oberfläche 18 realisiert werden. Denkbar ist es, die Oberfläche 18 gegebenenfalls mittels (Mikro-)Glasperlen, ähnlich dem Sandstrahlverfahren, zu bestrahlen oder im Tauchverfahren bzw. mit (Glas-)Ätzfolien anzuätzen. Hierfür geeignet wäre auch eine entsprechende (Vor-)Behandlung der Gieß- bzw. Spritzgußformen, die für die Herstellung der Glaskörper 16 benutzt werden, mit dem Effekt, daß die von den lichtemittierenden Elementen 12 ausgesandten Lichtstrahlen 26 auf der Oberfläche 18 des jeweiligen Gehäuses bzw. Glaskörpers 16 infolge Mehrfachbrechung gestreut werden.

In einer noch anderen Ausgestaltung der Erfindung können die lichtemittierenden Elemente 12 auch eine Form oder wenigstens einen Abschnitt aufweisen, die bzw. der eine lichtstreuende Wirkung ermöglicht (ebenfalls nicht dargestellt). So ist es denkbar, daß die lichtemittierenden Elemente 12 selbst jeweils als Streulinsen ausgebildet sind. Beispielsweise ist es möglich, daß die lichtemittierenden Elemente 12 bzw. deren Gehäuse oder Körper 16 die Form eines Kegels, einer Pyramide oder sonstigen Polygons annehmen. In entsprechender Weise können die Gehäuse bzw. Körper 16 der lichtemittierenden Elemente 12, die entsprechend den Fig. 1 bis 3 ein im wesentlichen zylinderförmig ausgebildetes Teil aufweisen und stirnseitig einen kalottenartigen oder halbkugelförmigen Abschnitt umfassen, mit einem kegel-, pyramiden- oder dergleichen -förmigen oder sonstwie polygonartigen Kopf bzw. Aufsatz anstelle des halbkugelförmigen Abschnitts versehen sein. Der Kopf bzw. Aufsatz könnte dabei gleichzeitig eine größere Grundfläche als der Querschnitt des zylinderförmigen Teils des Gehäuses 16 besitzen, vergleichbar mit einem Pilzkopf oder dergleichen. Sämtliche dieser Maßnahmen haben zur Folge, daß die im wesentlichen parallele Ausrichtung der Lichtstrahlen 26 in eine nach allen Richtungen verteilte (diffuse) Abstrahlung der (reflektierten) Lichtstrahlen 26 geändert wird.

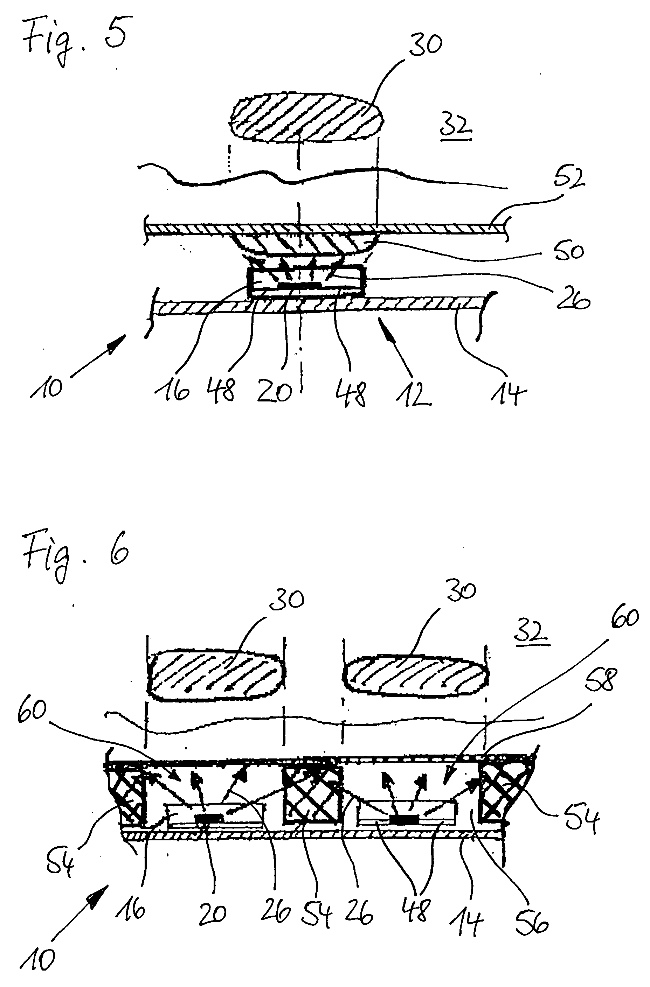

Die Fig. 5 zeigt ein Ausführungsbeispiel einer Displayanordnung 10 mit einem lichtemittierenden Element 12, das als Diode in Form eines oberflächenmontierbaren bzw. sogenannten SMD(surface mounted device)-LED-Elementes ausgebildet ist. Derartige lichtemittierende Elemente 12 zeichnen sich besonders durch ihre kleine Bauhöhe aus, die im allgemeinen nur ca. 0,8 mm beträgt, und sind mithin sehr flachbauend.

Die lichtemittierenden Elemente 12, die auf einer Leiterplatte 14 angeordnet sind, weisen jeweils ein Gehäuse 16, Körper oder dergleichen aus Kunststoffen oder Harzen bzw. Resinen auf, wie beispielsweise Epoxidharzen, auf. Das Gehäuse 16 dieser oberflächenmontierbaren lichtemittierenden Elemente 12, die derzeit auf dem Markt erhältlich sind, ist im wesentlichen flach und rechteckförmig, kann aber ebenso eine beliebig andere Form annehmen. In den Gehäusen 16 ist jeweils ein Halbleiterelement bzw. Chip bzw. Die 20 untergebracht, das über seitliche Kontaktflächen 48, welche an Leiter(-bahnen) (nicht gezeigt) an bzw. auf bzw. in der Leiterplatte 14 angeschlossen ist, mit Strom versorgbar ist.

Als Element zur Vergrößerung und/oder Formgebung sind den lichtemittierenden Elementen 12 bei der Ausführungsform der Displayanordnung 10 nach der Erfindung, die in der Fig. 5 näher dargestellt ist, jeweils eine Linse 50 oder dergleichen zugeordnet. Vorzugsweise handelt es sich bei den Linsen 50 um Sammellinsen. Die Linsen 50 bestehen in der Regel aus transparentem Kunststoff, wie Silikon, in optischer Qualität und Form.

Das lichtemittierende Element 12 in der Fig. 5 ist von der zugeordneten Linse 50 vollständig über- bzw. abgedeckt. Die Linse 50 ist zu dem lichtemittierenden Element 12 mittig ausgerichtet. Es ist jedoch ebenso denkbar, daß die Linsen 50 lediglich teilweise oberhalb der lichtemittierenden Elemente 12, zum Beispiel nur im unmittelbaren Bereich der Halbleiterbauelemente 20, angeordnet sind.

Die Linsen 50 sind dabei mittels Siebdruck- oder Dosiertechnik, d.h. in Tropfenform, auf einer tragenden bzw. abstützenden Lage 52, Schicht oder dergleichen aufgebracht, die den lichtemittierenden Elementen 12 zugeordnet ist, und zwar vorzugsweise diesen zugewandt. Diese Lage 52, Schicht oder dergleichen kann zum Beispiel die Frontscheibe des Gehäuses der Displayanordnung 10 sein.

Infolge der Linse 50 oberhalb des lichtemittierenden Elementes 12 ergibt sich in der Projektions- bzw. Bildebene 32 ein Leuchtpunkt 30 einer annähernd elliptischen Form bzw. einer ungefähren Rechteckform mit abgerundeten Ecken. Die Grundfläche des Leuchtpunktes 30 ist dabei entsprechend derjenigen der Linse 50 größer als die Grundfläche des lichtemittierenden Elementes 12.

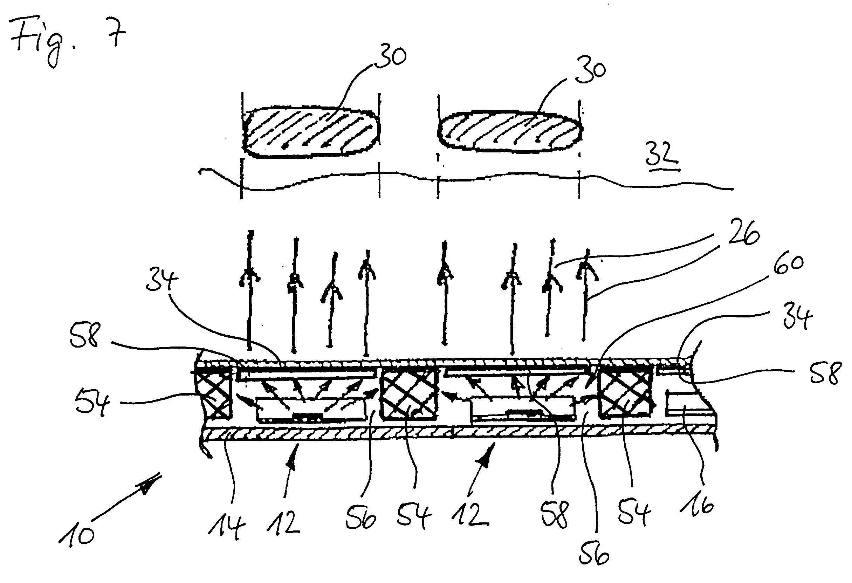

In der Fig. 6 ist eine abgeänderte Ausführungsform einer Displayanordnung 10 mit zwei lichtemittierenden Elementen 12 abgebildet. Den lichtemittierenden Elementen 12 sind zur verbesserten Formgebung Elemente 54 zur vollständigen oder auch nur teilweisen Abschirmung, beispielsweise Absorption oder Reflexion etc., von seitlichen Lichtstrahlen 26, die von den lichtemittierenden Elementen 12 ausgesendet werden, zugeordnet.

Auf bevorzugte Weise sind die lichtemittierenden Elemente 12 von dem jeweils zugeordneten lichtabschirmenden Element 54 mittig eingefaßt, wodurch im unmittelbaren Bereich der lichtemittierenden Elemente 12 jeweils eine Art Nest 56 entsteht. Da die lichtabschirmenden Elemente 54, die gegebenenfalls als Folie, Platte, scheibenförmiges Element oder dergleichen ausgestaltet sind, aus einer lichtundurchlässigen, ein- oder mehrschichtigen Gitterstruktur oder sonstigem Wabenmuster bestehen, ist eine seitliche Abstrahlung zuverlässig ausgeschlossen, zumindest stark eingeschränkt. Sofern eine mehrschichtige Gitterstruktur gewählt ist, können einander benachbarte Schichten über einen Klebstoff oder dergleichen miteinander verbunden werden.

Die lichtabschirmenden Elemente 54 sind bei dem Ausführungsbeispiel der Displayanordnung 10 nach der Fig. 6 an einer Lage 58, Schicht oder dergleichen auf der den lichtemittierenden Elementen 12 zugewandten Seite aufgebracht. Die Aufbringung der lichtabschirmenden Elemente 54 kann dabei mittels zum Beispiel der Siebdrucktechnik erfolgen.

Die Lage 58, Schicht oder dergleichen ist bei der Ausführungsform der Displayanordnung 10 der Fig. 6 zur selektiven Filterung von Lichtstrahlen 26 vorgesehen, die zweckmäßigerweise eine Filtercharakteristik aufweist, welche an die Wellenlänge der emittierten Lichtstrahlen 26 angepaßt ist. Somit stellt die lichtfilternde Lage 58, Schicht oder dergleichen ein alternatives oder kumulatives Element nach der Erfindung zur Vergrößerung und/oder Formgebung der ausgesendeten Lichtstrahlen 26 dar.

Entsprechend der Fig. 6 ist die lichtfilternde Lage 58, Schicht oder dergleichen als Folie, Platte, scheibenförmiges Element oder dergleichen ausgeführt. Beispielhafterweise kann die lichtfilternde Lage 58, Schicht oder dergleichen als Scheibe aus Glas oder Kunststoff ausgeführt sein, die selbst bereits lichtfilternde (Farb-)Pigmente enthält. Ein gesonderter Farbauftrag mit lichtfilternder Wirkung ist insoweit bei dieser erfindungsgemäßen Displayanordnung 10 nicht notwendig.

Es ist allerdings auch ohne weiteres denkbar, die lichtabschirmenden Elemente 54 nicht an der lichtfilternden Lage 58, Schicht oder dergleichen, sondern an einer tragenden bzw. die die Linsen 50 abstützenden Lage 52, Schicht oder dergleichen anzubringen, die optisch keine Filterwirkung besitzt.

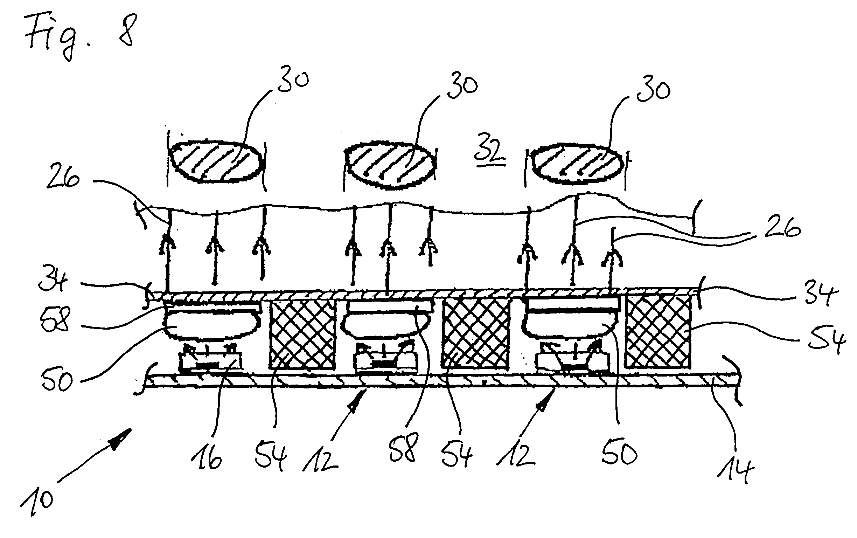

Wie sich der Fig. 7 deutlich entnehmen läßt, ist es demgegenüber jedoch konstruktiv gleichbedeutend, die lichtfilternde Lage 58, Schicht oder dergleichen lediglich abschnittsweise in den Bereichen 60 oberhalb der lichtemittierenden Elemente 12 vorzusehen. Die lichtfilternde Lage 58, Schicht oder dergleichen besteht dabei aus einem als selektiver Filter wirkenden Farbauftrag, der mittels Siebdrucktechnik auftragbar ist.

Die in der Fig. 7 gezeigte Ausführung einer erfindungsgemäßen Displayanordnung 10 unterscheidet sich darüber hinaus von derjenigen nach der Fig. 6 nur dadurch, daß den lichtemittierenden Elementen 12 eine Lage 34, Schicht oder dergleichen zur Streuung der Lichtstrahlen 26, welche von den lichtemittierenden Elementen 12 ausgesendet werden, zugeordnet ist. Durch Verwendung der lichtstreuenden Lage 34, Schicht oder dergleichen ergibt sich eine homogene Ausleuchtung der Bildpunkte 30 in der Projektions- bzw. Bildebene 32 und zugleich eine Vergrößerung der Leuchtfläche insgesamt.

Die lichtstreuende Lage 34, Schicht oder dergleichen übernimmt bei diesem Beispiel selbst die Funktion zum Tragen bzw. zur Aufnahme der einzelnen Abschnitte der lichtfilternden Lage 58, Schicht oder dergleichen, die oberhalb der lichtemittierenden Elemente 12 angeordnet sind. Eine gesonderte tragende Lage 52, Schicht oder dergleichen ist daher nicht erforderlich.

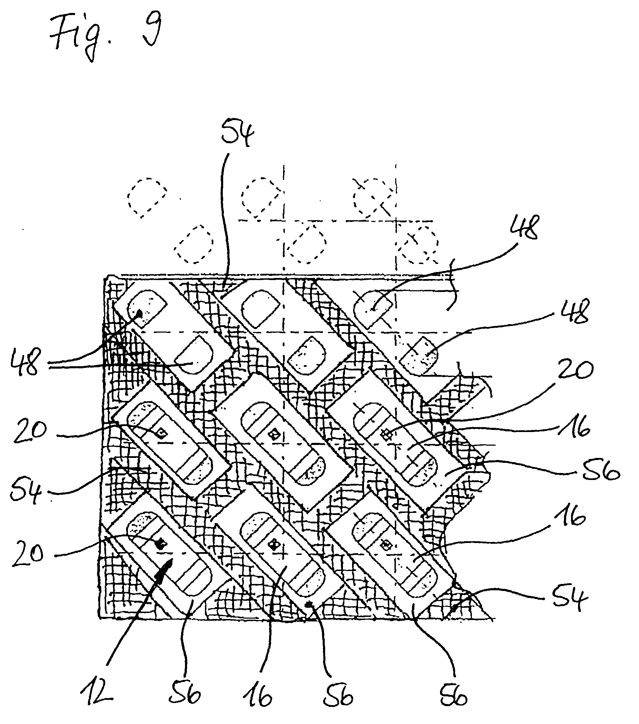

In der Fig. 8 ist eine noch andere Ausführungsform einer erfindungsgemäßen Displayanordnung 10 mit insgesamt drei lichtemittierenden Elementen 12 veranschaulicht, bei der es sich im wesentlichen um eine Kombination der Displayanordnungen 10 der vorhergehenden Ausführungsbeispiele gemäß den Fig. 5, 6 und 7 handelt.

Den lichtemittierenden Elementen 12 ist eine lichtstreuende Lage 34, Schicht oder dergleichen in Form einer Folie, Platte, einem scheibenförmigen Element oder dergleichen zugeordnet. An der lichtstreuenden Lage 34, Schicht oder dergleichen ist in den Bereichen 60 oberhalb der lichtemittierenden Elemente 12 jeweils eine lichtfilternde Lage 58, Schicht oder dergleichen aufgetragen. An der lichtfilternden Lage 58, Schicht oder dergleichen wiederum sind jeweils Linsen 50, insbesondere Sammellinsen, befestigt. Die lichtemittierenden Elemente 12 sind etwa mittig von ein- oder mehrschichtigen, lichtabschirmenden Elementen 54 umgeben, die eine seitliche Abstrahlung verhindern.

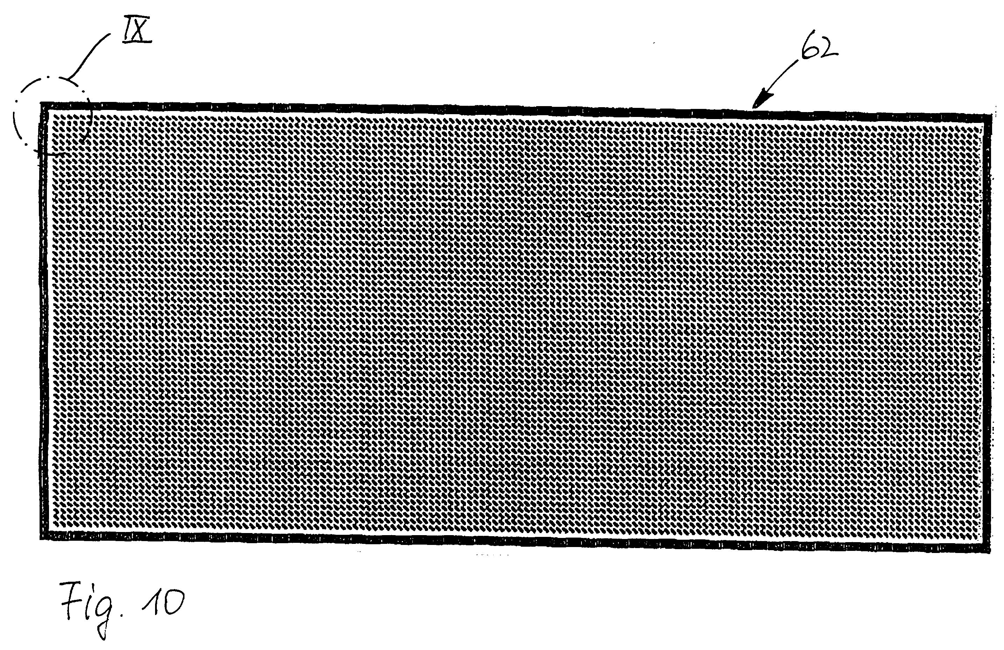

In der Fig. 9 ist zur weiteren Veranschaulichung der lichtemittierenden Elemente 12 der erfindungsgemäßen Displayanordnung 10 ein Ausschnitt aus einer Fläche 62 zum Anzeigen von Informationen, zum Beispiel einer Anzeigetafel im Bereich eines Bahnhofes, gemäß der Fig. 10 verdeutlicht.

Wie die Fig. 9 deutlich erkennen läßt, befinden sich die lichtemittierenden Elemente 12 in einer Diagonalen entsprechend einem Winkel von 45° zur Vertikalen bzw. Horizontalen, können aber auch in jeder anderen Winkelanordnung vorliegen. Die lichtemittierenden Elemente 12, die als oberflächenmontierbare LED-Elemente vorliegen, umfassen jeweils ein langestrecktes, rechteckförmiges Gehäuse 16, in das ein Halbleiterbauelement 20 außermittig eingegossen ist. Endseitig weist jedes lichtemittierende Element 12 Kontaktflächen 48 auf, die mit Leiter(-bahnen) an bzw. auf bzw. in der Leiterplatte 14 verbunden sind. Die Kontaktflächen 48 und Leiter(-bahnen) sind miteinander verlötet.

Jedes lichtemittierende Element 12 ist von einem lichtabschirmenden Element 54 der Gitterstruktur eingefaßt. Die lichtabschirmenden Elemente 54 sind hier aufgrund der geringfügigen Abstände benachbarter lichtemittierender Elemente 12 zusammenhängend ausgebildet. Jedes lichtabschirmende Element 54 bildet um das zugeordnete lichtemittierende Element 12 eine Art Nest 56. Die lichte Höhe der lichtabschirmenden Elemente entspricht ungefähr der Bauhöhe des dazugehörigen lichtemittierenden Elementes 12. Die sogenannten Nester 56 um die lichtemittierenden Elemente 12 enthalten die Linsen 50 aus transparentem Silikon.

Die Erfindung ist nicht auf die beschriebenen Ausführungsformen der Displayanordnung 10 nach den Fig. 1 bis 10 beschränkt. So ist es durchaus denkbar, sämtliche zuvor erwähnten Elemente 24, 34, 36, 40, 50, 54, 58 zur Vergößerung und/oder Formgebung der von den lichtemittierenden Elementen 12 ausgesendeten Lichtstrahlen 26 in Alleinstellung oder jeder beliebigen Kombination zueinander vorzusehen.

Beispielsweise läßt sich eine seitliche Abstrahlung von den lichtemittierenden Elementen 12 alternativ erreichen, indem die lichtabschirmenden Elemente 54 bei den Ausführungsformen der erfindungsgemäßen Displayanordnung 10 nach den Fig. 5 bis 8 durch Reflektoren 24 entsprechend dem Ausführungsbeispiel der Displayanordnung 10 nach einer der Fig. 1 bis 3 ersetzt werden. So besteht auch die Möglichkeit, anstelle einer lichtstreuenden Lage 34, Schicht oder dergleichen in den Ausführungsformen der Fig. 2 und 3 eine lichtfilternde Lage 58, Schicht oder dergleichen gemäß dem Beispiel aus den Fig. 6 bis 8 zu realisieren. Die zu realisierenden Kombinationen hängen lediglich von den räumlichen Gegenheiten und sonstigen technischen Vorgaben des Benutzers ab und lassen sich individuell auswählen.

Auch müssen die Reflektoren 24 und/oder die Linsen 50 und/oder die lichtabschirmenden Elemente 54 jeweils nicht unbedingt voneinander separiert sein, sondern können ebenso in Form einer Lage, Schicht oder dergleichen miteinander zusammenhängend ausgebildet sein. Ebenfalls ist es möglich, die lichtstreuende Lage 34 und/oder Schicht oder dergleichen und/oder die lichtkontrastverstärkende Lage 40, Schicht oder dergleichen und/oder die tragende Lage 52, Schicht oder dergleichen und/oder die lichtfilternde Lage 58, Schicht oder dergleichen nicht zusammenhängend, sondern als individuelle, voneinander unabhängige Abschnitte auszuformen.

### Bezugszeichenliste

- 10: Displayanordnung
- 12: lichtemittierende Elemente
- 14: Leiterplatte
- 16: Gehäuse, Körper oder dergleichen
- 18: (äußere) Oberfläche der Gehäuse bzw. Körper
- 20: Halbleiterbauelement bzw. Chip bzw. Die
- 22: Leiter(-bahnen)
- 24: Reflektoren
- 26: Lichtstrahlen
- 28: Loch- oder dergleichen -maske
- 30: Leuchtpunkte
- 32: Projektions- bzw. Bildebene
- 34: lichtstreuende Lage, Schicht oder dergleichen
- 36: lichtkontrastverstärkende Oberfläche
- 38: Bereiche zwischen einander benachbarten Reflektoren
- 40: lichtkontrastverstärkende Lage, Schicht oder dergleichen
- 42: wirksame Bereiche der Reflektoren
- 44: Ausnehmungen oder Aussparungen
- 46: Matrix
- 48: Kontaktflächen
- 50: Linsen
- 52: tragende, aufnehmende Lage, Schicht oder dergleichen
- 54: lichtabschirmende Elemente
- 56: Nester
- 58: lichtfilternde Lage, Schicht oder dergleichen
- 60: Bereiche oberhalb der lichtemittierenden Elemente
- 62: Fläche zum Anzeigen von Informationen.

## Patentansprüche

1. Displayanordnung zum Anzeigen von Informationen mit einer Vielzahl von lichtemittierenden Elementen (12), die zueinander benachbart angeordnet und individuell ansteuerbar sind, wobei den lichtemittierenden Elementen (12) wenigstens ein Element (24, 34, 36, 40, 50, 54, 58) zur Vergrößerung und/oder Formgebung der von den lichtemittierenden Elementen (12) ausgesendeten Lichtstrahlen (26) zugeordnet ist.

2. Displayanordnung nach Anspruch 1, dadurch gekennzeichnet, daß den lichtemittierenden Elementen (12) Reflektoren (24) oder dergleichen zugeordnet sind.

3. Displayanordnung nach Anspruch 2, dadurch gekennzeichnet, daß die lichtemittierenden Elemente (12) jeweils von dem zugeordneten Reflektor (24) eingefaßt, insbesondere in der Mitte des Reflektors (24), angeordnet sind, wobei die Reflektoren (24) vorzugsweise an einer Loch- oder dergleichen -maske (28) angeordnet oder in einer Loch- oder dergleichen -maske (28) integriert sind, wobei die Reflektoren (24) und/oder die Loch- oder dergleichen -maske (28) vorteilhafterweise aus weißem und/oder schwarzem reflektierenden, Lichtstrahlen (26) undurchlässigen Material, insbesondere Kunststoff, gebildet ist/sind.

4. Displayanordnung nach einem der Ansprüche 1 bis 3, dadurch gekennzeichnet, daß den lichtemittierenden Elemente (12) Linsen (50), insbesondere Sammellinsen, oder dergleichen zugeordnet sind.

5. Displayanordnung nach Anspruch 4, dadurch gekennzeichnet, daß die lichtemittierenden Elemente (12) jeweils von der zugeordneten Linse (50), welche insbesondere mittig ausgerichtet ist, über- bzw. abgedeckt sind, wobei die Linsen (50) vorzugsweise aus transparentem Kunststoff, insbesondere aus Silikon, ausgebildet sind, wobei den lichtemittierenden Elementen (12) vorteilhafterweise eine Lage (52), Schicht oder dergleichen zum Tragen der Linsen (50), welche insbesondere den lichtemittierenden Elementen (12) zugewandt sind, zugeordnet ist.

6. Displayanordnung nach einem der Ansprüche 1 bis 5, dadurch gekennzeichnet, daß den lichtemittierenden Elementen (12) Elemente (54) oder dergleichen zur Abschirmung, insbesondere zur Absorption, Reflexion oder dergleichen, von seitlichen Lichtstrahlen (26) zugeordnet sind.

7. Displayanordnung nach Anspruch 6, dadurch gekennzeichnet, daß die lichtemittierenden Elemente (12) jeweils von dem zugeordneten lichtabschirmenden Element (54) eingefaßt, insbesondere in der Mitte des lichtabschirmenden Elementes (54) angeordnet sind, wobei die lichtabschirmenden Elemente (54) vorzugsweise als Folie, Platte, scheibenförmiges Element oder dergleichen, insbesondere aus einer lichtundurchlässigen, ein- oder mehrschichtigen Gitterstruktur, ausgebildet sind.

8. Displayanordnung nach einem der Ansprüche 1 bis 7, dadurch gekennzeichnet, daß den lichtemittierenden Elementen (12) eine Lage (58), Schicht oder dergleichen zur selektiven Filterung von Lichtstrahlen (26) zugeordnet ist, deren Filtercharakteristik insbesondere auf die Wellenlänge der von den lichtemittierenden Elementen (12) ausgesendeten Lichtstrahlen (26) abgestimmt ist.

9. Displayanordnung nach Anspruch 8, dadurch gekennzeichnet, daß die lichtfilternde Lage (58), Schicht oder dergleichen als Folie, Platte, scheibenförmiges Element oder dergleichen ausgebildet ist, wobei die lichtfilternde Lage (58), Schicht oder dergleichen vorteilhafterweise zumindest abschnittsweise in den Bereichen (60) über den lichtemittierenden Elementen (12) vorgesehen ist.

10. Displayanordnung nach Anspruch 8 oder 9, dadurch gekennzeichnet, daß die lichtfilternde Lage (58), Schicht oder dergleichen aus einem Farbauftrag besteht, der als selektiver Filter wirkt.

11. Displayanordnung nach einem der Ansprüche 1 bis 10, dadurch gekennzeichnet, daß den lichtemittierenden Elementen (12) eine Lage (34), Schicht oder dergleichen zur Streuung der Lichtstrahlen (26) zugeordnet ist.

12. Displayanordnung nach Anspruch 11, dadurch gekennzeichnet, daß die lichtstreuende Lage (34), Schicht oder dergleichen als Folie, Platte, scheibenförmiges Element oder dergleichen, insbesondere aus Kunststoff, faserverstärktem Kunststoff oder Glas, ausgebildet ist, wobei die lichtstreuende Lage (34), Schicht oder dergleichen auf den Reflektoren (24), den Linsen (50), der tragenden Lage (52), Schicht oder dergleichen, den lichtabschirmenden Elementen (54) oder der lichtfilternden Lage (58), Schicht oder dergleichen, über den lichtemittierenden Elementen (12), angebracht, insbesondere aufgeklebt, ist.

13. Displayanordnung nach einem der Ansprüche 5 bis 12, dadurch gekennzeichnet, daß als Lage (52), Schicht oder dergleichen zum Tragen der Linsen (50) und/oder der lichtabschirmenden Elemente (54) die lichtfilternde Lage (58), Schicht oder dergleichen und/oder die lichtstreuende Lage (34), Schicht oder dergleichen vorgesehen ist/sind.

14. Displayanordnung nach einem der Ansprüche 1 bis 9, dadurch gekennzeichnet, daß die lichtemittierenden Elemente (12) wenigstens teilweise eine Oberfläche (18) zur Streuung der Lichtstrahlen (26) aufweisen.

15. Displayanordnung nach Anspruch 14, dadurch gekennzeichnet, daß die lichtemittierenden Elemente (12) jeweils ein Gehäuse (16), einen Körper oder dergleichen aufweisen, dessen lichtstreuende Oberfläche (18) durch Bestrahlung mit (Mikro-)Glasperlen oder Anätzen mittels Tauchverfahren oder Ätzfolien gebildet ist.

16. Displayanordnung nach Anspruch 14 oder 15, dadurch gekennzeichnet, daß die lichtstreuende Oberfläche (18) des Gehäuses (16), Körpers oder dergleichen der lichtemittierenden Elemente (12) unmittelbar oder durch entsprechende (Vor-) Behandlung der, zu ihrer Herstellung verwendeten, Gieß- bzw. Spritzgußform mittelbar herstellbar ist.

17. Displayanordnung nach einem der Ansprüche 1 bis 10, dadurch gekennzeichnet, daß die lichtemittierenden Elemente (12) eine Form oder wenigstens einen Abschnitt zur Streuung der Lichtstrahlen (26) aufweisen.

18. Displayanordnung nach einem der Ansprüche 1 bis 17, dadurch gekennzeichnet, daß Bereiche (38) zwischen einander benachbarten Reflektoren (24) eine lichtkontrastverstärkende Oberfläche (36) aufweisen oder den Bereichen (38) zwischen einander benachbarten Reflektoren (24) eine Lage (40), Schicht oder dergleichen zur Verstärkung des Lichtkontrastes zugeordnet ist.

19. Displayanordnung nach Anspruch 18, dadurch gekennzeichnet, daß die lichtkontrastverstärkende Lage (40), Schicht oder dergleichen als Folie, Platte, scheibenförmiges Element oder dergleichen, insbesondere aus Kunststoff, faserverstärktem Kunststoff oder Glas, ausgebildet ist, die in den wirksamen Bereichen (42) der Reflektoren (24) mit Ausnehmungen (44) oder Aussparungen versehen ist, wobei die lichtkontrastverstärkende Lage (40), Schicht oder dergleichen vorzugsweise dunkel, insbesondere schwarz, matt, mattglänzend oder strukturiert ausgebildet ist.

20. Displayanordnung nach einem der Ansprüche 17 bis 19, dadurch gekennzeichnet, daß die lichtkontrastverstärkende Lage (40), Schicht oder dergleichen in den Bereichen (38) zwischen einander benachbarten Reflektoren (24) auf den Reflektoren (24) und/oder der Loch- oder dergleichen -maske (28) und/oder auf der lichtstreuenden Lage (34), Schicht oder dergleichen angebracht, insbesondere aufgeklebt, ist.

21. Displayanordnung nach einem der Ansprüche 1 bis 20, dadurch gekennzeichnet, daß die Reflektoren (24) und/oder die Linsen (50) und/oder die lichtabschirmenden Elemente (54) und/oder die lichtfilternde Lage (58), Schicht oder dergleichen und/oder die lichtstreuende Lage (34), Schicht oder dergleichen und/oder die lichtkontrastverstärkende Lage (40), Schicht oder dergleichen derart ausgebildet ist/sind, daß die in der Projektionsebene (32) erzeugten Leuchtpunkte (30) kreisförmig, ellipsoid, dreieckig, viereckig oder sonstwie polygonal sind.

22. Displayanordnung nach einem der Ansprüche 1 bis 21, dadurch gekennzeichnet, daß die lichtemittierenden Elemente (12) als Dioden, insbesondere in Form von (oberflächenmontierbaren) LED-Elementen, ausgebildet sind.

23. Displayanordnung nach einem der Ansprüche 1 bis 22, dadurch gekennzeichnet, daß die lichtemittierenden Elemente (12) zueinander in Form einer Matrix (46) oder dergleichen angeordnet sind, die insbesondere mit weiteren Matrizen (46) aus lichtemittierenden Elementen (12) eine Fläche (62) zum Anzeigen der Informationen bilden.

24. Verwendung der Displayanordnung nach einem der Ansprüche 1 bis 23 in einem Land- und/oder Luft- und/oder Wasserfahrzeug, insbesondere in einem Schienenfahrzeug, Flugzeug, Schiff oder dergleichen, zur Beförderung von Personen und/oder zum Transport von sonstigen Lebewesen oder Gegenständen, oder in einem stationären System, insbesondere im Bereich von Bahnhöfen, Flughäfen oder sonstigen Haltestellen von Land- und/oder Luft- und/oder Wasserfahrzeugen, in einem Regalsystem von Einkaufsmärkten, Lagerhäusern etc.

25. Verfahren zur Herstellung einer Displayanordnung zum Anzeigen von Informationen, insbesondere nach einem der Ansprüche 1 bis 24, mit einer Vielzahl von lichtemittierenden Elementen (12), die zueinander benachbart angeordnet und individuell ansteuerbar sind, wobei die Reflektoren (24) oder dergleichen und/oder die lichtstreuende Lage (34), Schicht oder dergleichen und/oder die lichtkontrastverstärkende Oberfläche (36) oder Lage (40), Schicht oder dergleichen, die Linsen (50) oder dergleichen und/oder die tragende Lage (52), Schicht oder dergleichen und/oder die lichtabschirmenden Elemente (54) oder dergleichen und/oder die lichtfilternde Lage (58), Schicht oder dergleichen und/oder die lichtstreuende Lage (34) Schicht oder dergleichen durch (Sieb-)Drucktechnik oder Dosiertechnik oder dergleichen Beschichtungstechnik und/oder durch Bestrahlung mit (Mikro-) Glasperlen und/oder durch Anätzen mittels Tauchverfahren bzw. Ätzverfahren gebildet werden.
